# EUROPEAN PATENT APPLICATION

(11) **EP 4 589 609 A1**
(43) Date of publication of application: **23.07.2025**
(21) Application number: 24189310.6
(22) Date of filing: 18.07.2024
(51) Int. Cl.: H01F 17/00

(54) **STRUCTURE AND METHOD FOR AN INDUCTOR HAVING A WINDING WITH A FIRST SEGMENT CONNECTED TO TWO SECOND SEGMENTS**

(30) Priority: 18.01.2024 US 202418416466
(71) Applicant: GlobalFoundries U.S. Inc., Malta, NY 12020 (US)
(72) Inventor: Prawoto, Clarissa Cyrilla, 01109 Dresden (DE); Rohlfs, Patrick, 01108 Dresden (DE)
(74) Representative: Grünecker Patent- und Rechtsanwälte PartG mbB

(57) **Abstract**

The disclosure provides a structure and method for an inductor having a winding with a first segment connected to two second segments. An inductor (100) according to the disclosure includes a plurality of windings (104) coupled together in series about a magnetic core (102). At least one of the plurality of windings includes a first segment (106) in a first wiring layer and extending over a width of the magnetic core. A second segment (110) is within a second wiring layer and coupled to the first segment through a vertical interconnect (108). The second segment includes two sub-segments (111a, 111b) separated by a gap along a length of the magnetic core.

## Description

### BACKGROUND

The disclosure provides a structure and method for an inductor having a winding with a first segment connected to two second segments.

Integration of soft magnetic materials (i.e., materials that can become magnetized or demagnetized at relatively low energy levels) into integrated circuits (ICs) has benefited device performance, particularly in the case of inductors, transformers, and/or other components which operate using magnetic fields. Components featuring soft magnetic materials, however, suffer from limitations in maximum current achievable in the device due to the saturation of magnetic flux produced from magnetic fields within the soft magnetic material(s). That is, the current may not increase beyond a particular maximum when the magnetic field strength in the inductor is too high, causing the inductor to be functionally indistinguishable from other implementations relying on air gaps and/or other open space as a medium for magnetic fields. Hybrid device structures combining soft magnetic materials with empty space may offer higher saturation currents but undesirably limit magnetic flux density.

### SUMMARY

The illustrative aspects of the present disclosure are designed to solve the problems herein described and/or other problems not discussed.

Embodiments of the disclosure provide a structure including: an inductor including a plurality of windings coupled together in series about a magnetic core, wherein at least one of the plurality of windings includes: a first segment in a first wiring layer and extending over a width of the magnetic core, and a second segment within a second wiring layer and coupled to the first segment through a vertical interconnect, wherein the second segment includes two sub-segments separated by a gap along a length of the magnetic core.

Other embodiments of the disclosure provide a structure including: a magnetic core having a length within a pair of wiring layers of a device; and an inductor including a plurality of windings coupled together in series about the magnetic core, wherein at least one of the plurality of windings includes: a first segment in a first wiring layer and extending over a width of the magnetic core, and a second segment within a second wiring layer and coupled to the first segment through a vertical interconnect, wherein the second segment includes two sub-segments separated by a gap along a length of the magnetic core.

Additional embodiments of the disclosure provide a method including: providing an inductor including a plurality of windings coupled together in series about a magnetic core, wherein at least one of the plurality of windings includes: a first segment in a first wiring layer and extending over a width of the magnetic core, and a second segment within a second wiring layer and coupled to the first segment through a vertical interconnect, wherein the second segment includes two sub-segments separated by a gap along a length of the magnetic core; and transmitting a current through the inductor to induce a magnetic flux within the magnetic core to induce a flux density in a first portion of the magnetic core within the second segment of the winding that is less than a flux density in a second portion of the magnetic core within the first segment of the winding.

Two or more aspects described in this disclosure, including those described in this summary section, may be combined to form implementations not specifically described herein.

The details of one or more implementations are set forth in the accompanying drawings and the description below. Other features, objects and advantages will be apparent from the description and drawings, and from the claims.

### BRIEF DESCRIPTION OF THE DRAWINGS

These and other features of this disclosure will be more readily understood from the following detailed description of the various aspects of the disclosure taken in conjunction with the accompanying drawings that depict various embodiments of the disclosure, in which:
FIG. 1 shows a first top-down view of a structure according to embodiments of the disclosure.
FIG. 2shows a plan view of a first segment and second segment in a structure according to embodiments of the disclosure.
FIG. 3 shows a side view of a structure, viewed from line 3-3 of FIG. 1, according to embodiments of the disclosure.
FIG. 4 shows a partial plan view of a first segment and magnetic core in a structure according to embodiments of the disclosure.
FIG. 5 shows a partial plan view of a second segment and magnetic core in a structure according to embodiments of the disclosure.

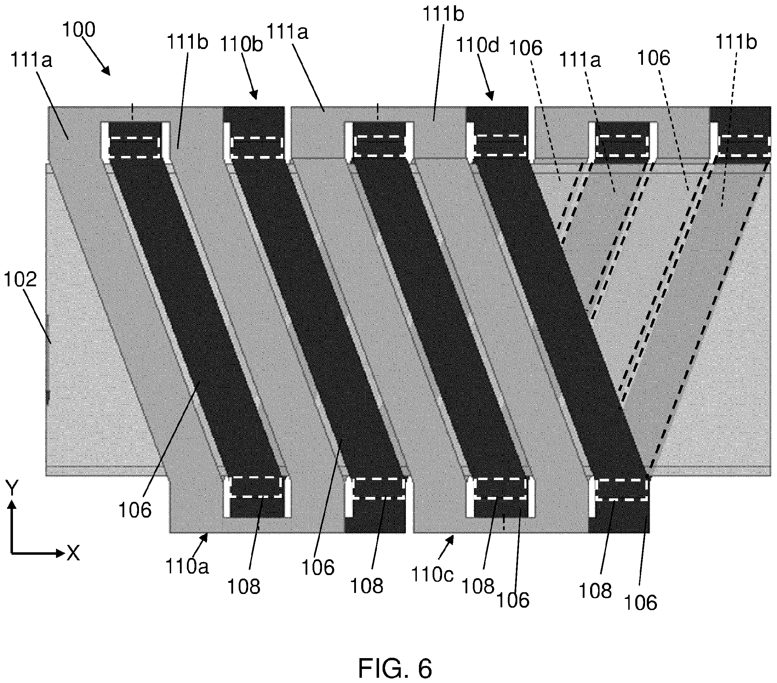

FIG. 6 shows a second plan view of a structure according to further embodiments of the disclosure.
FIG. 7 shows a plan view of a structure with annotated magnetic field regions during use in methods according to the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (a) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

The disclosure provides a structure and method for an inductor having a winding with a first segment connected to two second segments. An inductor according to the disclosure includes a plurality of windings coupled together in series about a magnetic core. At least one of the plurality of windings includes a first segment in a first wiring layer and extending over a width of the magnetic core. A second segment is within a second wiring layer and coupled to the first segment through a vertical interconnect. The second segment includes two sub-segments separated by a gap along a length of the magnetic core. Transmitting a current through the inductor induces a magnetic flux within the magnetic core. The windings intermittently splitting into two or more sub-segments reduces a current density in certain sections of the inductor and similarly reduces the flux density in portions of the magnetic core that are adjacent the sub-segments. Among other benefits, structures of the disclosure produce less flux density within the magnetic core across a longer span of the magnetic core and thereby accommodate higher saturation currents.

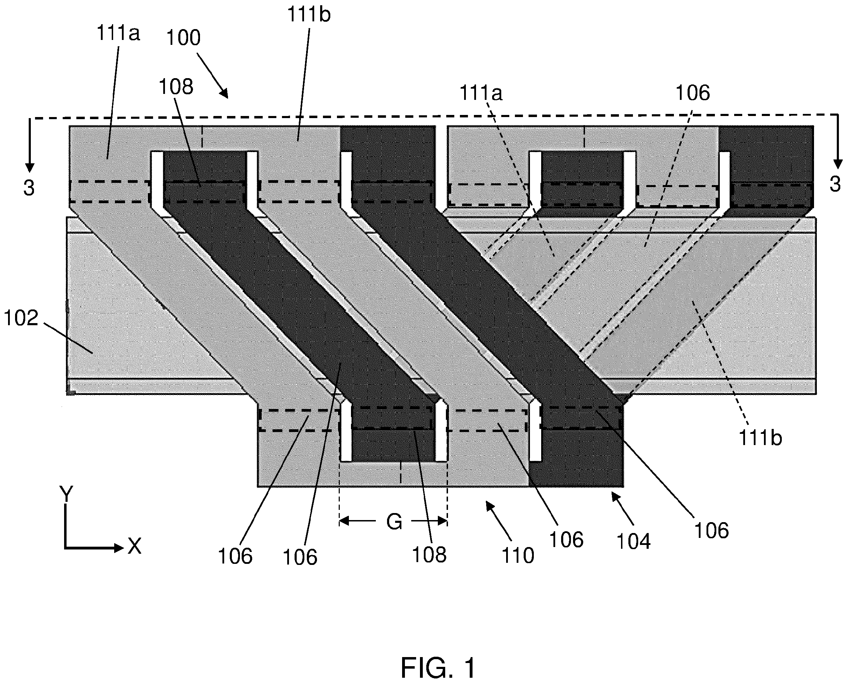

FIG. 1 shows a first plan view of an inductor 100, which may be integrated into an IC structure and/or various other microelectronic devices. Inductor 100 may surround a magnetic core 102, which may include any solid magnetic core material capable of being magnetized through the principles of inductance. Magnetic core 102 may be formed of one or more "soft magnetic materials," i.e., currently known or later developed substances capable of exhibiting a magnetic field in response to relatively low amounts of inductive current in a wire thereon. Examples of materials appropriate for use within magnetic core 102 include, without limitation: cobalt-zirconium-tantalum alloys, iron-silicon alloys, nickel-iron alloys, ferrous (i.e., iron-based) materials such as "electronic iron," steel and soft ferrite, amorphous and nano-crystalline alloys, etc. Magnetic core 102 is illustrated by example as being substantially rectangular and nearly planar (i.e., having negligible depth relative to length and width), but it is understood that magnetic core 102 may have any of a variety of other shapes (e.g., cylindrical geometries, prismatic geometries, etc.).

Inductor 100 may include various subcomponents formed of a conductive material (e.g., copper (Cu), aluminum (Al), and/or other materials suitable for use as conductive wires). During operation, the conductive material(s) of inductor 100 when subjected to an electric current will create a magnetic field to oppose increasing and decreasing electric currents within the span of inductor 100. Inductor 100, as discussed herein, may be subdivided into a plurality of individual windings 104 that together define conductive loops within inductor 100. It is emphasized that each winding 104 includes portions that into and out of the plane of the page to define multiple loops of conductive material, even when this is not directly visible in some perspectives.

Inductor 100 includes a plurality of windings 104 coupled together in series about magnetic core 102. As discussed herein, portions of each winding 104 may be interleaved with portions of other windings 104 to make use of any available space surrounding magnetic core 102. In addition, each winding 104 may be shaped for interleaving with complementary shaped portions in another winding 104. Each of the various windings 104 within inductor 100 may include a conductive material (e.g., copper (Cu), aluminum (Al), and/or other conductors discussed herein) and may be subdivided into segments of varying shape.

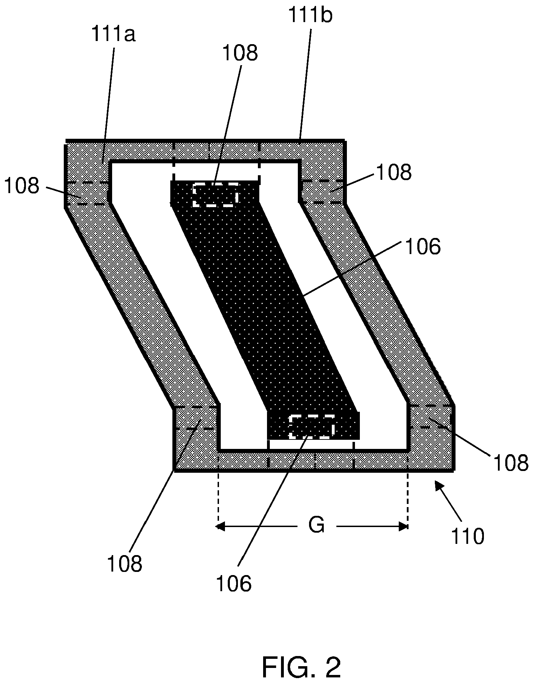

Referring now to FIGS. 1 and 2, each winding 104 (FIG. 1 only) of inductor 100 may include, e.g., a first segment 106 extending diagonally widthwise over magnetic core 102. First segment 106 may be substantially planar and may connect to other segments of winding 104 through an interconnect 108 extending vertically along a height of magnetic core 102. First segment 106 may be within a first wiring layer of an integrated circuit (IC) structure and may be located a distance above magnetic core 102 to prevent electrical shorting from inductor 100 to magnetic core 102. Interconnect 108, similarly, may be horizontally distal to magnetic core 102 to prevent electrical shorting from interconnect 108 to magnetic core 102.

Each winding 104 also may include a second segment 110 connected in series to first segment 106 through interconnect 108. Together, one first segment 106 and one second segment 110 may define a single "turn" of one winding 104 within inductor 100. Second segment 110 may include two sub-segments 111a, 111b. Each sub-segment 111a, 111b may be in a different wiring layer from first segment(s) 106, yet they may be in the same vertically adjacent wiring layer of a device. Although second segments 110 (and sub-segments 111a, 111b thereof) of winding 104 each may be similar or even identical in size and shape, this is not necessarily required in all implementations. Sub-segments 111a, 111b of second segment 110 may extend diagonally over magnetic core 102 in a different direction from first segment(s) 106 to which they connect. As discussed in more detail herein, first segment(s) 106 and second segment 110 each have an orientation that together defines a substantial V-shape in the X-Y plane. Each set of two or more sub-segments 111a, 111b may be coupled to one first segment 106 through respective interconnects 108. Furthermore, sub-segments 111a, 111b may be structurally continuous portions of second segment 110. Windings 104 may be similar or identical in shape, but also may be in different positions. Thus, first segments 106 of one winding 104 will interleave with second segments 110 of another winding 104 (i.e., first segment 106 is between sub-segments 111a, 1 1 1b). Second segments 110 of the same winding will also interleave with first segments 106 of the other winding 104.

Second segment 110 may have a looped, substantially parallelogrammatic shape with a hollow interior (i.e., gap G between sub-segments 111a, 111b). The looped shape of second segment 110 allows first segment 106 of another winding to be placed therein. In second segment 110, each sub-segment 111a, 111b is defined as approximately one side or one half of the conductive material of second segment 110. In this case, sub-segments 111a, 111b may be oriented in parallel to each other within the wiring layer of a device where they are formed. In this case, portions of second segment 110 in one winding 104 may horizontally surround first segment(s) 106 of another winding 104. Portions of sub-segments 111a, 111b extending over the width of magnetic core 102 may be separated by a gap G along the length of magnetic core 102. Gap G may have any size sufficient to prevent current from crossing between sub-segments 111a, 111b in locations other than their terminal end(s). In some cases, gap G may be larger than the width of first segment(s) 106 of another winding 104 in inductor 100. To provide compact usage of space, first segment(s) 106 of another winding 104 may be located within gap G between two sub-segments 111a, 111b but with sufficient horizontal separation to prevent electrical shorting from first segment(s) 106 into sub-segment(s) 111a, 111b or vice versa.

During operation, electric current passing through one first segment 106 of winding 104 is distributed over sub-segment 111a, 111b of second segment 110. Each sub-segment 111a, 111b of second segment 110 has less current than the entire current transmitted through first segment 106. Each first segment 106 of one winding 104 may be in the same wiring layer of an IC structure, and each second segment 110 of the same winding 104 may be in a different wiring layer yet may also be in a vertically adjacent wiring layer of the IC structure. Where inductor 100 includes multiple windings 104 about magnetic core 102, one wiring layer may include first segments 106 of one winding 104 alternating with second segments 110 of another winding 104 in the same wiring layer. Each winding 104 may include only first segments 106 in one wiring layer and only second segments 110 in another wiring layer. FIG. 1 depicts an example of first segments 106 alternating with sub-segments 111a, 111b of second segment 110 on each side of magnetic core 102 (i.e., in the same wiring layer). Each winding 104 of inductor 100 may include one or more first segments 106 connected in series to second segment(s) having sub-segments 111a, 111b (e.g., through interconnect 108), such that windings 104 of inductor 100 are interleaved with each other along the length of magnetic core 102.

Interconnects 108 of inductor 100 may couple first segments 106 to second segments 110 in series. Interconnects 108 are shown in FIG. 2 with dashed lines to indicate couplings from one wiring layer to another wiring layer that is in a cross-section that is in front of, or behind, the plane illustrated in FIG. 2. To aid in electrical communication and or distribution between segments 106, 110, interconnect(s) 108 may be located horizontally between magnetic core 102 and a lengthwise end of the segment(s) 106, 110 where they appear. Interconnect(s) 108 being in such a position may be especially desirable where sub-segments 111 in one wiring layer horizontally surround an adjacent portion of first segment 106 in the same wiring layer, e.g., so first segment 106 does not physically contact the position where sub-segments 111 are coupled together. In further implementations, segments 106, 110 may be coupled through a larger number (e.g., two or more) interconnects 108. Other numbers and arrangements of interconnects 108 are also possible.

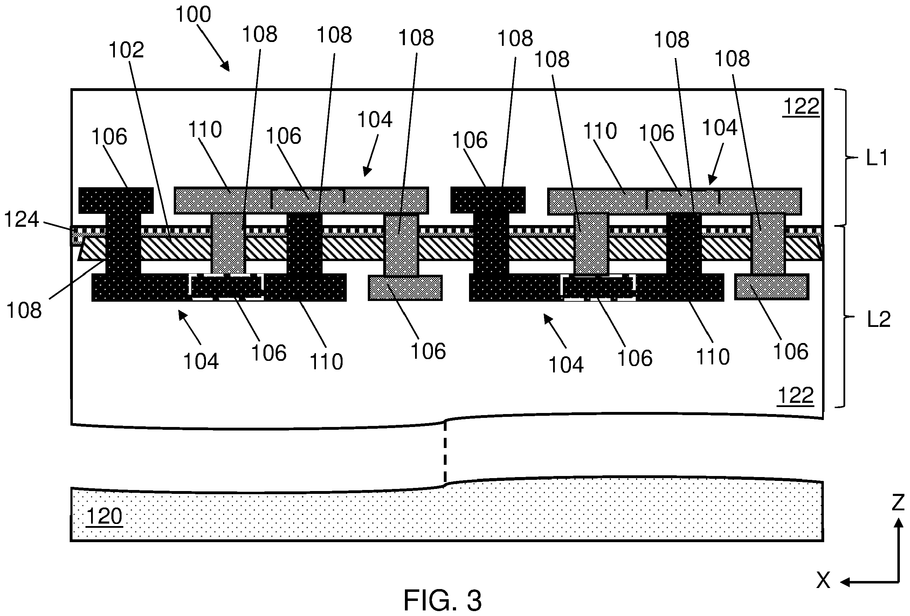

FIG. 3 provides a side view of inductor 100 from the perspective of view line 3-3 of FIG. 1. It is emphasized that, within in FIG. 3, differences in shading indicate different windings 104 and not different segments 106, 110. Inductor 100 as shown may be structurally integrated into other components of a device. Inductor 100 may be over a substrate 120, e.g., one or more semiconductor materials. Substrate 120 may include but is not limited to silicon, germanium, silicon germanium, silicon carbide, or any other common IC semiconductor or packaging substrates. A portion or all the entire semiconductor substrate 120 may be strained. Substrate 120 is illustrated as a bulk semiconductor layer, but this is not required in all implementations. Substrate 120 may include various devices (e.g., transistors, capacitors, diodes, etc.) thereon in other locations not shown.

An inter-level dielectric (ILD) layer 122 may be on substrate 120. ILD layer 122 may include any currently known or later developed insulating material appropriate for separating various layers of a device from each other, e.g., any material also appropriate for use as or within a trench isolation (TI) for electrically separating various regions of active semiconductor material. Such materials may include, without limitation: silicon nitride (Si₃N₄), silicon oxide (SiO₂), fluorinated SiO₂ (FSG), hydrogenated silicon oxycarbide (SiCOH), porous SiCOH, boro-phospho-silicate glass (BPSG), silsesquioxanes, carbon (C) doped oxides (i.e., organosilicates) that include atoms of silicon (Si), carbon (C), oxygen (O), and/or hydrogen (H), thermosetting polyarylene ethers, a spin-on silicon-carbon containing polymer material, near frictionless carbon (NFC), or layers thereof. However embodied, ILD layer 122 may vertically separate active materials of inductor 100 from other active materials that may be on or within substrate 120, and/or other active or conductive components formed in various metal wiring layers in a device.

Inductor 100 may be formed on ILD layer 122, e.g., by removing portions of ILD layer 122 material to a desired amount (e.g., by etching or other currently known or later developed processing techniques) and forming inductor 100 and magnetic core 102 on the remaining portions of ILD layer 122. In the example shown, second segment 110 and one or more sub-segments 111 thereof may be formed within ILD layer 122. Magnetic core 102 may be formed over second segment 110 by re-forming insulative material over second segment 110, and interconnect(s) 108 may be formed on second segment 110. In other cross-sections and/or implementations, first segment(s) 106 may be formed on ILD layer 122 and may be adjacent second segment 110 as shown in other views herein.

An insulative liner 124 may be on ILD layer 122 and over magnetic core 102 to vertically separate ILD layer 122 from other ILD layers 122 formed thereover. Insulative liner 124 may include a different type of insulator from ILD layer(s) 122, e.g., it may include nitride in the case where ILD layer 122 includes oxide insulators. Insulative liner(s) 124, during processing, may function as an "etch stop layer" to control where certain wires, vias, etc., will be formed in a structure and thus may define the upper boundary of a device layer or metal wiring layer thereover. Insulative liner 124, and other materials (including ILD layer 122) thereon may define one wiring layer of a device (i.e., layer "L1" of FIG. 3). Other materials below insulative liner 124 (including ILD layer 122 thereunder) may define another wiring layer of a device (i.e., layer "L2" of FIG. 3). The broken lines between substrate 120 and ILD layers 122 indicate that there may be any desired number of device and/or wiring layers between substrate 120 and layers L1, L2.

Portions of each winding 104 in inductor 100 may be formed in different wiring layers. For example, inductor 100 may be distributed over a device layer and a metal wiring layer thereover, or otherwise may be distributed over two different metal wiring layers. FIG. 3 depicts the example of two metal wiring layers L1, L2, but the description herein is equally applicable to inductors 100 formed in any combination of device layers and/or metal wiring layers each having insulative material(s) therein and/or therebetween. FIG. 3 depicts a side view of inductor 100, and not a cross-section. Thus, some portions of each winding 104, and segment 106, 110 may be in different horizontal planes. Dashed lines appear in FIG. 3 to indicate where portions of a segment 106, 110 are horizontally behind overlapping portions of another segment 106, 110. During manufacture, first segment(s) 106 of inductor 100 may be formed in wiring layer L1 on interconnect(s) 108 and insulative liner 124 after other portions of inductor 100 are formed in layer L2 thereunder. In various other portions of inductor 100, and/or other embodiments, second segment(s) 110 and sub-segments 111 may be formed in wiring layer L1 and first segment(s) 106 may be formed in wiring layer L2. Magnetic core 102 is illustrated in wiring layer L2 in FIG. 3, but it may be in wiring layer L1 and/or any other wiring layer of a device in further embodiments. Wherever located, portions of inductor 100 can be formed in desired wiring layer(s) L1, L2, e.g., by repeated instances of forming and etching ILD layer(s) 122 and insulative liner(s) 124. When the forming of one metal wiring layer (e.g., wiring layer L2, including ILD layer 122 and insulative liner 124 thereof) concludes, inductor 100 may not yet be complete.

Before additional layers and/or insulative materials are formed over insulative liner 124, the forming of each winding 104 in inductor 100 may include forming (e.g., by deposition) additional conductive material in the form of first segments 106 and/or adjacent second segment(s) 110 and sub-segments 111 thereof. Segment(s) 106, 110 and/or sub-segment(s) 111 thus may be in ILD layer 122 of wiring layer L1, such that they are on an upper surface of insulative liner 124 and may physically interface with the upper surfaces of vertical interconnects 108 formed through insulative liner 124 but may be vertically distal to magnetic core 102. Upon forming segments 106, 110 and interconnects 108 therebetween inductor 100 defines an electrically conductive pathway from one terminal to another and is operable to induce magnetic fields within magnetic core 102. The forming of segments 106, 110, sub-segments 111, and/or interconnects 108 may define the locations where conductive metals are formed, and may include deposition of metals followed by planarization (e.g., chemical mechanical planarization (CMP), etc. Aspects of these processes may be controlled to provide varying widths and/or pitches in different portions of inductor 100.

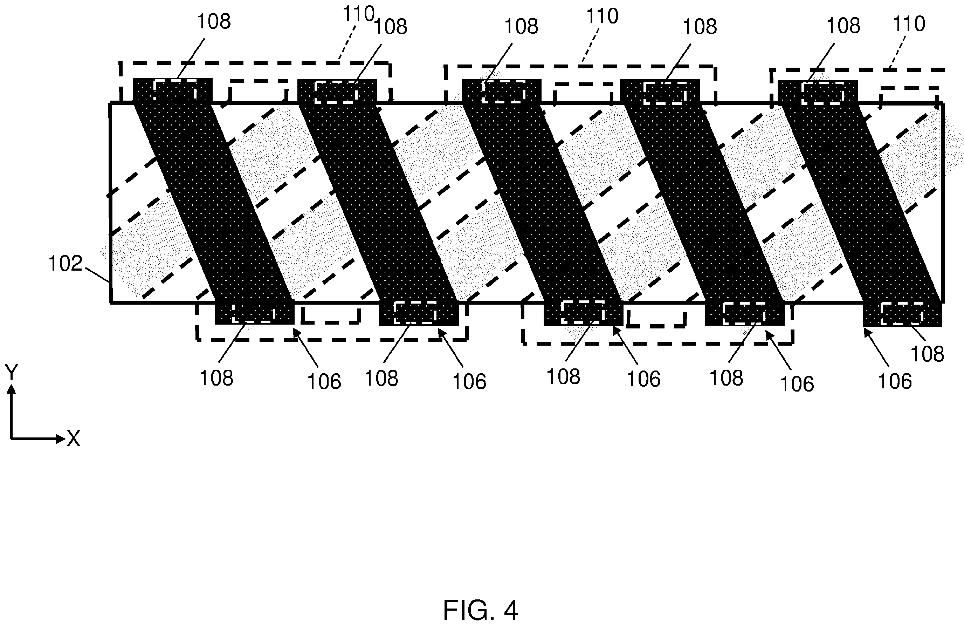

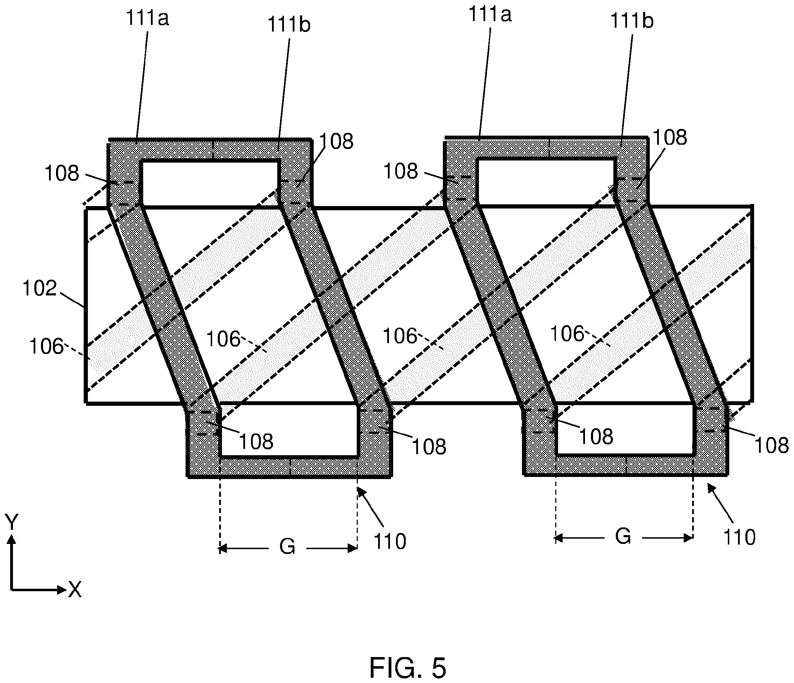

Referring to FIGS. 4 and 5, first segment 106 (FIG. 4 only) may be shaped for interleaving with second segment 110 (FIG. 5 only) and sub-segments 111a, 111b (FIG. 5 only) thereof along the length of magnetic core 102. FIGS. 4 and 5 each show only one of the two segments 106, 110 for sake of explanation and clarity of illustration. First segments 106 may take on a substantial bridge shape, e.g., by extending diagonally over the width of magnetic core 102 from one interconnect 108 to another. Within wiring layer L1 (FIG. 3), a middle portion of first segment 106 may be substantially planar (i.e., it may have an insignificant vertical thickness) and may extend linearly between a pair of interconnects 108. Each interconnect 108 may couple one of a pair of first segments 106 to one sub-segment 111a, 111b of second segment 110 below magnetic core 102.

FIG. 5 depicts second segments 110 of inductor 100 in the same wiring layer (e.g., wiring layer L1 (FIG. 3)) as first segment 106 (FIG. 4.) As discussed, second segments 110 include sub-segments 111a, 111b which together define a substantially parallelogrammatic geometry within wiring layer L1. Thus, each second segment 110 does not extend linearly from one interconnect 108 to another, but instead forms a looping shape above magnetic core 102 and within wiring layer L1. The looping shape of each second segment 110 defines gap G (FIG. 5 only) between sub-segments 111a, 11 1b. The location of interconnect(s) 108 to first segment 106 may be within the loop formed by second segment 110, allowing first segment(s) 106 to be placed within gap G over magnetic core 102. First segments 106 thus may be interleaved with, and horizontally surrounded by, an adjacent second segment 1110 within wiring layer L1. Among other advantages, this structural configuration allows multiple windings 104 of inductor 100 to be adjacent each other within one wiring layer but with a size that limits current density within each segment. The lower current densities within inductor 100 as compared to conventional inductors may be provided, e.g., by subdividing second segment 110 into sub-segments 111a, 111b and by interconnected each second segment 110 through two first segments 106 as shown.

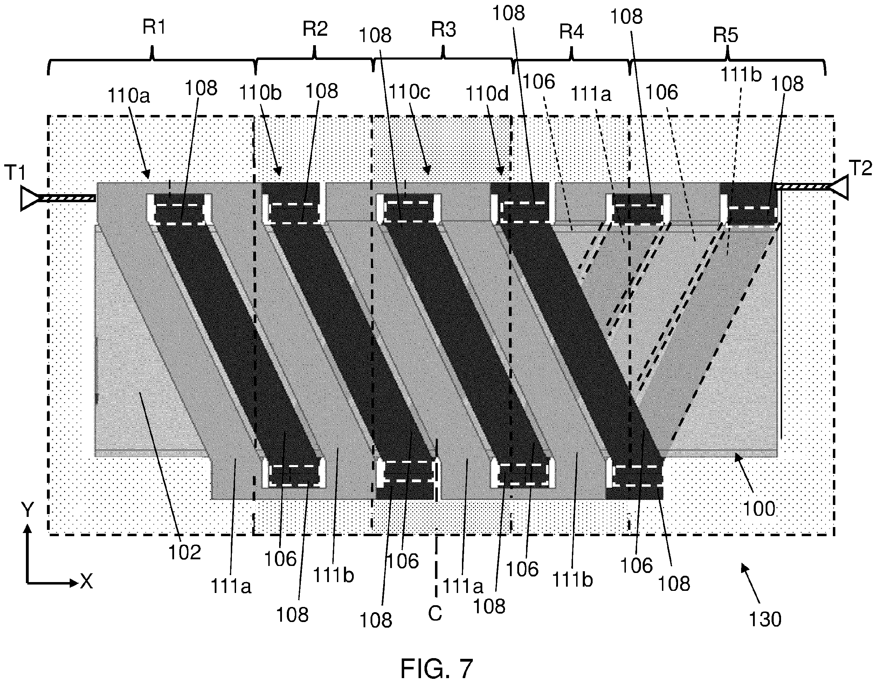

Referring to FIG. 7, the interleaving of first segments 106 with second segments 110 of inductor 100 allows the size of inductor 100 to be customized based on magnetic core 102 length. As shown, first segments 106 may be located horizontally adjacent (and may be horizontally surrounded by) an interleaved second segment 110 in multiple wiring layers of a device. Moreover, the location of two first segments 106 on one vertical side of magnetic core 102 may correspond to the location of one second segment 110 and sub-segments 111a, 111b thereof on the opposite side of magnetic core 102. The substantial V-shape formed by the different, opposite orientations of each segment 106, 110 on opposite sides of magnetic core 102 allows first segments 106 and second segments 110 to alternate with each other along the length of magnetic core 102, thus providing a scalable inductor structure. For example, two second segments 110a, 110b, 110c, 110d are shown in the illustrated portion of inductor 100. Two segments 110a, 110c alternate with first segments 106 in one wiring layer above magnetic core 102. Two other second segments 110b, 110d alternate with first segments 106 in another wiring layer below magnetic core 102.

FIG. 7 depicts a plan view of an integrated circuit (IC) structure 130 including inductor 100 during operation, in which an electric current is transmitted between opposing terminals T1, T2 of inductor 100. Terminals T1, T2 may be coupled to current sources and/or ground where applicable, and remaining components of a device are omitted from FIG. 7 solely for ease of illustration. According to an example, terminal T1 is coupled to a current source and terminal T2 is coupled to ground such that current flows from terminal T1 to terminal T2. Inductor 100, as structured according to the disclosure, may be subdivided into five regions: a first region R1 at the connection to terminal T1, a second region R2 coupled to region R1 opposite terminal T1, a third region R3 coupled to region R2, a fourth region R4 coupled to region R3, and a fifth region R5 coupled between fourth region R4 and terminal T2. Regions R1, R5, each may include only a portion of one first segment 106 and one second segment 110 of inductor 100, as well as portions of inductor 100 that are coupled to terminal T1 or T2, respectively. Additionally, regions R2 and R4 may include portions of multiple first segments 106 and second segments 110, or in some cases, may include entire first segments 106 and/or second segments 110. Region R5, which includes a center C of magnetic core 102, also may include at least portions of multiple first segments 106 and second segments 110.

As discussed herein, first segments 106 and second segments 110 of inductor 100 may be interleaved yet may be shaped to distribute current density over more physical space than is possible in conventional inductors. The increased current distribution may arise from the presence of sub-segments 111a, 111b in second segment 110 and the position of first segments 106 within the space between sub-segments 111a, 111b. During operation, currents through segments 106, 110 of inductor 100 may produce a lower amount of magnetic flux (and thus flux density) in magnetic core 102 by distributing the current within inductor 100 over a larger number of material without increasing the number of "turns" relative to a conventional inductor. In a conventional inductor having turns of substantially uniform shape, and thus similar size or width, the magnetic field strength (measured, e.g., in amperes per meter (A/m)) may exceed 1500 A/m, or even be as high as 1900 A/m. These higher strength magnetic fields may appear at or near the center of the conventional inductor structure. Magnetic fields of such high strength may reduce the saturation (i.e., maximum allowed) current through an inductor, thus limiting its technical applications.

Inductor 100 according to the disclosure can be employed in integrated in IC structures without exhibiting these unacceptably high magnetic field strengths. In embodiments of the disclosure, the peak magnetic field strength may be in regions R2, R4 may be at most approximately 1500 A/m, and more specifically may be between approximately 1300 A/m and approximately 1400 A/m. The higher magnetic field strength in regions R2, R4 may arise from having less conductive material about magnetic core 102 than in region R5, where multiple portions of multiple segments 106, 110 are present, and/or distance of these regions from terminal(s) T1, T2. In regions R1, R3, R5, the magnetic field strength may be lower and may range from approximately 700 A/m to approximately 1200 A/M. The magnetic field strength through regions R1-R5 thus is more uniformly distributed than possible in conventional inductor structures formed around and/or relying on magnetic cores. These operational benefits arise from the shape and/or interleaving of segments 106, 110 in each region as discussed herein, and in turn may allow higher amounts of current to pass through inductor 100 without the current saturating at an undesirably low magnitude. In contrast, conventional inductor structures have a maximum saturation current that is limited by the peak magnetic field strength that its windings 104 produce. Thus, methods according to the disclosure include providing inductor 100 according to any embodiment herein, and passing a current through inductor 100 (e.g., from terminal T1 to terminal T2) to induce a magnetic flux within magnetic core 102. The flux density in a first portion of inductor 100 (e.g., region R2 or region R4 discussed herein) may be larger than the flux density in region R3 of inductor 100, which includes second segment(s) 110 and passes through center C of inductor 100.

Embodiments of the disclosure provide various technical and commercial advantages, examples of which are discussed herein. Embodiments of inductor 100 and/or IC structure 130 (FIG. 7) allow magnetic core 102 to be used in a product without limiting the maximum current in inductor 100 before saturation. These benefits may be achieved using segments 106, 110 with different shapes (e.g., including sub-segments 111a, 111b in a looped shape) and without forming slots and/or air gaps within inductor 100 or nearby components. As discussed herein, embodiments of the disclosure may decrease magnetic field density by approximately twenty-five percent in areas of inductor 100 that pass over, or are located near, center C where magnetic field strength would otherwise be highest. This, in turn, more uniformly distributes the magnetic field strength through magnetic core 102 during operation.

The method and structure as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a center processor.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about," "approximately," and "substantially," are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, the disclosure provides a structure and method for an inductor having a winding with a first segment connected to two second segments. An inductor according to the disclosure includes a plurality of windings coupled together in series about a magnetic core. At least one of the plurality of windings includes a first segment in a first wiring layer and extending over a width of the magnetic core. A second segment is within a second wiring layer and coupled to the first segment through a vertical interconnect. The second segment includes two sub-segments separated by a gap along a length of the magnetic core.

The following embodiments are explicitly disclosed.

### Embodiment 1:

A structure comprising:
an inductor including a plurality of windings coupled together in series about a magnetic core,
wherein at least one of the plurality of windings includes:
   a first segment in a first wiring layer and extending over a width of the magnetic core, and
   a second segment within a second wiring layer and coupled to the first segment through a vertical interconnect, wherein the second segment includes two sub-segments separated by a gap along a length of the magnetic core.

In some illustrative examples of embodiment 1, the structure defined by embodiment 1 may be an inductor structure.

### Embodiment 2:

The structure of embodiment 1, wherein an orientation of the first segment and an orientation of the second segment together define a substantial V-shape.

### Embodiment 3:

The structure of embodiment 1 or 2, wherein the two sub-segments of the second segment are oriented in parallel to each other within the second wiring layer.

### Embodiment 4:

The structure of one of embodiments 1 to 3, wherein a portion of a first segment of another winding of the inductor is within the gap between the two sub-segments of the second segment.

### Embodiment 5:

The structure of one of embodiments 1 to 4, wherein the second segment horizontally surrounds a first segment of another winding of the inductor.

### Embodiment 6:

The structure of one of embodiments 1 to 5, wherein each of the plurality of windings of the inductor includes the first segment and the second segment having the two sub-segments, and each of the respective vertical interconnects is between the magnetic core and a lengthwise end of the first segment.

### Embodiment 7:

The structure of one of embodiments 1 to 6, wherein each of the plurality of windings of the inductor includes the first segment and the second segment having the two sub-segments, and each winding of the inductor is interleaved with another winding along the length of the magnetic core.

### Embodiment 8:

A device structure comprising:
a magnetic core having a length within a pair of wiring layers of a device; and
an inductor including a plurality of windings coupled together in series about the magnetic core, wherein at least one of the plurality of windings includes:
   a first segment in a first wiring layer and extending over a width of the magnetic core, and
   a second segment within a second wiring layer and coupled to the first segment through a vertical interconnect, wherein the second segment includes two sub-segments separated by a gap along a length of the magnetic core.

In some illustrative examples of embodiment 8, the structure defined by embodiment 8 may be an integrated circuit (IC) structure, i.e., an IC structure comprising the structure, preferably inductor structure, of one of embodiments 1 to 7 with the plurality of windings of the inductor structure being coupled together in series about the magnetic core of the IC structure.

In some particularly illustrative examples of embodiment 8, a device structure may be provided, the device structure comprising a magnetic core having a length within a pair of wiring layers of a device, and the structure of one of embodiments 1 to 7, wherein the plurality of windings of the inductor is coupled together in series about the magnetic core.

### Embodiment 9:

The device structure of embodiment 8, wherein an orientation of the first segment and an orientation of the second segment together define a substantial V-shape.

### Embodiment 10:

The device structure of embodiment 8 or 9, wherein the two sub-segments of the second segment are oriented in parallel to each other within the second wiring layer.

### Embodiment 11:

The device structure of one of embodiments 8 to 10, wherein the second segment horizontally surrounds a first segment of another winding of the inductor.

### Embodiment 12:

The device structure of one of embodiments 8 to 11, wherein each of the plurality of windings of the inductor includes the first segment and the second segment having the two sub-segments, and each of the respective vertical interconnects is between the magnetic core and a lengthwise end of the first segment.

### Embodiment 13:

The device structure of one of embodiments 8 to 12, wherein each of the plurality of windings of the inductor includes the first segment and the second segment having the two sub-segments.

### Embodiment 14:

The device structure of embodiment 13, wherein each winding of the inductor is interleaved with a respective adjacent winding along the length of the magnetic core.

### Embodiment 15:

A method comprising:
providing an inductor including a plurality of windings coupled together in series about a magnetic core, wherein at least one of the plurality of windings includes:
   a first segment in a first wiring layer and extending over a width of the magnetic core, and
   a second segment within a second wiring layer and coupled to the first segment through a vertical interconnect, wherein the second segment includes two sub-segments separated by a gap along a length of the magnetic core; and
transmitting a current through the inductor to induce a magnetic flux within the magnetic core to induce a flux density in a first portion of the magnetic core within the second segment of the winding that is less than a flux density in a second portion of the magnetic core within the first segment of the winding.

### Embodiment 16:

The method of embodiment 15, wherein each of the plurality of windings of the inductor includes the first segment and the second segment having the two sub-segments, and each of the respective vertical interconnects is between the magnetic core and a lengthwise end of the first segment.

### Embodiment 17:

The method of embodiment 15, wherein the two sub-segments are oriented in parallel to each other within the second wiring layer.

### Embodiment 18:

The method of embodiment 15, wherein a portion of a first segment of another winding of the inductor is within the gap between the two sub-segments.

### Embodiment 19:

The method of embodiment 15, wherein the second segment horizontally surrounds a first segment of another winding of the inductor.

### Embodiment 20:

The method of embodiment 15, wherein each of the plurality of windings of the inductor includes the first segment and the second segment having the two sub-segments, and each winding of the inductor is interleaved with another winding along the length of the magnetic core.

### Embodiment 21:

The method of one of embodiments 15 to 20, wherein at least one of the structure of one of embodiments 1 to 7 and the device structure of one of embodiments 8 to 14 is formed.

At least in the embodiments above, the term "include" and its variants may be interpreted as meaning that an embodiment includes stated features, while not necessarily excluding the presence of other features that are not explicitly stated.

## Claims

1. A structure comprising:
an inductor including a plurality of windings coupled together in series about a magnetic core, wherein at least one of the plurality of windings includes:
a first segment in a first wiring layer and extending over a width of the magnetic core, and
a second segment within a second wiring layer and coupled to the first segment through a vertical interconnect, wherein the second segment includes two sub-segments separated by a gap along a length of the magnetic core.

2. The structure of claim 1, wherein an orientation of the first segment and an orientation of the second segment together define a substantial V-shape.

3. The structure of claim 1 or 2, wherein the two sub-segments of the second segment are oriented in parallel to each other within the second wiring layer.

4. The structure of one of claims 1 to 3, wherein a portion of a first segment of another winding of the inductor is within the gap between the two sub-segments of the second segment.

5. The structure of one of claims 1 to 4, wherein the second segment horizontally surrounds a first segment of another winding of the inductor.

6. The structure of one of claims 1 to 5, wherein each of the plurality of windings of the inductor includes the first segment and the second segment having the two sub-segments, each of the respective vertical interconnects preferably being between the magnetic core and a lengthwise end of the first segment.

7. The structure of one of claims 1 to 6, wherein each of the plurality of windings of the inductor includes the first segment and the second segment having the two sub-segments, and each winding of the inductor is interleaved with another winding along the length of the magnetic core.

8. A device structure, comprising:
a magnetic core having a length within a pair of wiring layers of a device; and
the structure of one of claims 1 to 7, wherein the plurality of windings of the inductor is coupled together in series about the magnetic core.

9. The device structure of claim 8, wherein each of the plurality of windings of the inductor includes the first segment and the second segment having the two sub-segments, each winding of the inductor preferably being interleaved with a respective adjacent winding along the length of the magnetic core.

10. A method comprising:
providing an inductor including a plurality of windings coupled together in series about a magnetic core, wherein at least one of the plurality of windings includes:
a first segment in a first wiring layer and extending over a width of the magnetic core, and
a second segment within a second wiring layer and coupled to the first segment through a vertical interconnect, wherein the second segment includes two sub-segments separated by a gap along a length of the magnetic core; and
transmitting a current through the inductor to induce a magnetic flux within the magnetic core to induce a flux density in a first portion of the magnetic core within the second segment of the winding that is less than a flux density in a second portion of the magnetic core within the first segment of the winding.

11. The method of claim 10, wherein each of the plurality of windings of the inductor includes the first segment and the second segment having the two sub-segments, and each of the respective vertical interconnects is between the magnetic core and a lengthwise end of the first segment.

12. The method of claim 10 or 11, wherein the two sub-segments are oriented in parallel to each other within the second wiring layer.

13. The method of one of claims 10 to 12, wherein a portion of a first segment of another winding of the inductor is within the gap between the two sub-segments.

14. The method of one of claims 10 to 13, wherein the second segment horizontally surrounds a first segment of another winding of the inductor.

15. The method of one of claims 10 to 14, wherein each of the plurality of windings of the inductor includes the first segment and the second segment having the two sub-segments, and each winding of the inductor is interleaved with another winding along the length of the magnetic core.
